# EUROPEAN PATENT APPLICATION

(11) **EP 2 499 970 A1**
(43) Date of publication of application: **19.09.2012**
(21) Application number: 10828032.2
(22) Date of filing: 17.06.2010
(51) Int. Cl.: A61B 5/055, G01R 33/48

(54) **METHOD AND DEVICE FOR PRODUCING MAGNETIC RESONANCE ELASTOGRAM (MRE) AND BALL VIBRATOR FOR PRODUCING MAGNETIC RESONANCE ELASTOGRAM (MRE)**

(30) Priority: 09.11.2009 JP 2009256251
(71) Applicant: Tokyo Metropolitan University, Tokyo 163-8001 (JP)
(72) Inventor: NUMANO, Tomokazu, Noda-shi Chiba 278-0003 (JP); KAWABATA, Yoshihiko, Hino-shi Tokyo 191-0065 (JP)
(74) Representative: Henkel, Breuer & Partner
(86) International application number: PCT/JP2010/004037
(87) International publication number: WO 2011/055469

(57) **Abstract**

A ball vibrator that generates vibrations caused by a centrifugal force along with the rotation of a nonmagnetic ball around the center point in the circumferential direction is disposed so as to come into contact with a predetermined part of an object, an image of which is to be formed. Then, a magnetic resonance elastogram (MRE) pulse sequence is applied to the object, and a magnetic resonance elastogram (MRE) is created by using the vibrations from the ball vibrator.

## Description

### TECHNICAL FIELD

The present invention relates to a method for producing a magnetic resonance elastogram (MRE), a device for producing the MRE and a ball vibrator for producing the MRE.

### BACKGROUND ART

A X-ray CT (Computer Tomography) is employed as a diagnostic means which can conduct the detection and localization of diseased tissue. In this diagnostic means, an X-ray is irradiated onto one plane crossing a human subject at various angles and the thus obtained data are reconstructed by a computer to be converted into the corresponding images so that the detection and localization of the diseased tissue can be conducted on the images. According to this method, the intended images can be obtained in a relatively short period of time, but the use of contrast medium and the radiation exposure burden the human subject and the contrast resolution is not sufficient.

Recently, in this point of view, an MRI (Magnetic Resonance Imaging, hereinafter, the term "MRI" is often employed as an abbreviation for a Magnetic Resonance imaging device) technique is being employed. In this technique, the magnetism in hydrogen nuclei (protons) contained in each of tissues in a human subject is utilized so that the burden for the human subject originated from the use of contrast agent and radiation exposure can be reduced and the contrast resolution in the thus obtained i mages is relatively higher than the one of the CT. In the MRI, moreover, the imaging is not disturbed by the bones of the human subject, different from the X-ray imaging, so that the images of vertebrae, spinal cord and cartilage can be obtained and the images relating to the concentration distribution of metabolite and the motional behavior of molecule can be also obtained, allowing early diagnosis for diseased tissue such as in a state of bad metabolism or blood flow.

In the MRI technique, however, since the diagnosis for the hardness of the diseased tissue or the like cannot be conducted, the diagnosis for a tumor of which the hardness of the diseased tissue (e.g., a liver tumor) mainly changes cannot be sufficiently conducted.

In this point of view, in the MRI technique, such an attempt as applying an alternate stress to the human subject so as to produce a magnetic resonance elastogram (MRE) is made. In this case, when the shear waves generated from the alternative stress are propagated in the interior of the human subject and reached to the diseased tissue and the peripheral tissues, the phases of the NMR signals relating to the diseased tissue and the peripheral tissues become different from one another if the hardness of the diseased tissue are different from the hardness of the peripheral tissues. Since the phase changes are reflected on the MRE, the hardness of the diseased tissue can be recognized by observing the MRE in addition to the high contrast resolution inherently belonging to the MRI technique.

In the case that the alternate stress is applied to the human subject, since a strong magnetic field is generated in the MRI, a mechanical alternate stress applying means such as a motor cannot be directly disposed in the MRI.

In this point of view, Patent document No. 1 discloses that a vibrating plate is disposed so as to be contacted with the human subject in the MRI and vibrated by the load of sound pressure generated by a voice coil from the outside of the MRI in order to generate the alternate stress. In this method, however, if the voice coil is away from the vibrating plate to some degree, the vibration energy of the sound pressure is largely attenuated on the use of the sound pressure, resulting in the generation of a not sufficient alternate stress. As a result, such an intended MRE cannot be produced.

### RIOR ART REFERENCE

### Patent Reference

Reference 1: JP-A 2006-3147784 (KOKAI)

### DISCLOSURE OF THE INVENTION

### (Problem to be solved by the Invention)

It is an object of the present invention to make possible the production of a magnetic resonance elastogram (MRE) using a magnetic resonance imaging device (MRI) by a sufficient alternative stress.

### (Technical Solution)

In order to achieve the object of the present invention, the present invention relates to a method for producing a magnetic resonance elastogram (MRE) using a magnetic resonance imaging device (MRI), including the steps of: disposing a ball vibrator to generate a vibration caused by a centrifugal force accompanied by a rotation of a non-magnetic ball in a circumferential direction thereof around a center point thereof so as to be contacted with a prescribed portion of a subject of which an image is produced; and producing a magnetic resonance elestogram (MRE) by employing a magnetic resonance elastogram (MRE) pulse sequence to the subject and using the vibration from the ball vibrator.

The present invention also relates to a device for producing a magnetic resonance elastogram (MRE) using a magnetic resonance imaging device (MRI), including: a ball vibrator disposed so as to be contacted with a prescribed portion of a subject of which an image is formed in a magnetic resonance imaging device (MRI) and for applying to the subject a vibration caused by a centrifugal force accompanied by a rotation of a non-magnetic ball in a circumferential direction thereof around a center point thereof; and an MRE pulse sequence generating means for generating a magnetic resonance elastogram (MRE) pulse sequence to be employed for the subject and producing a magnetic resonance elastogram (MRE) in cooperation with the vibration from the ball vibrator.

Moreover, the present invention relates a ball vibrator for producing a magnetic resonance elastogram (MRE) which is configured so as to generate a vibration caused by a centrifugal force accompanied by a rotation of a non-magnetic ball in a circumferential direction thereof around a center point thereof in contacted with a prescribed portion of a subject of which an image is formed.

According to the present invention, the ball vibrator, which generates the vibration caused by the centrifugal force accompanied by the rotation of the non-magnetic ball in the circumferential direction thereof around the center point thereof, is disposed in contact with a human subject. In this case, since the vibration of the ball vibrator is applied directly to the human subject, an alternate stress can be sufficiently applied to the human subject. Therefore, since the shear waves caused by the alternate stress can be propagated in the interior of the human subject and reached to the diseased tissue, the intended magnetic resonance elastogram (MRE) reflecting the hardness of the diseased tissue can be produced.

With regard to a tumor (e.g., of a liver or breast) of which the hardness of the diseased tissue changes as the human subject's condition is getting worse, the condition of the tumor can be easily recognized by observing the magnetic resonance elastogram (MRE) so as to diagnose the diseased tissue of the tumor.

Since the magnetic resonance elastogram (MRE) is produced using the magnetic resonance imaging device (MRI), the function/effect inherently belonging to the MRI of small burden on human subject originated from non-use of contrast agent and non-radiation exposure, and high contrast resolution can be exhibited. Moreover, the imaging is not disturbed by the bones of the human subject, different from the X-ray imaging, so that the images of vertebrae, spinal cord and cartilage can be obtained and the images relating to the concentration distribution of metabolite and the motional behavior of molecule can be also obtained, allowing the diagnosis for diseased tissue such as in a state of bad metabolism or blood flow.

In an aspect of the present invention, the rotation of the non-magnetic ball in the circumferential direction of the ball vibrator is caused by a pressure of air. In this case, a large load can be applied to the ball in comparison of a conventional technique using the sound pressure so that the rotation of the ball can be conducted at high velocity. As a result, a large vibration can be caused by the centrifugal force accompanied by the high velocity rotation, and the aforementioned function/effect can be conspicuously exhibited.

In another aspect of the present invention, the ball vibrator includes a light sensor so that the rotational number of the non-magnetic ball in the circumferential direction is monitored by the on/off frequency of the light frequency. In this case, since the rotational velocity of the ball, rotated in the circumferential direction of the ball vibrator, is always monitored by the light sensor, the rotational number of the ball can be always controlled constantly by controlling the pressure of air appropriately. As a result, the constant vibration, that is, the alternate stress can be always applied to the human subject and the intended MRE reflecting the hardness of the diseased tissue can be easily produced.

On the other hand, since the rotational number of the ball in the circumferential direction in the ball vibrator can be always monitored, the rotational number can be freely controlled so that in view of the hardness of the diseased tissue, the vibration, that is, the alternate stress commensurate with the diseased tissue can be freely formed. As a result, the intended magnetic resonance elastogram (MRE) commensurate with the hardness of the diseased tissue can be appropriately produced.

### (Advantageous Effect)

According to the present invention, the production of a magnetic resonance elastogram (MRE) using a magnetic resonance imaging device (MRI) is made possible by a sufficient alternative stress.

### BRIEF DESCRIPTION OF THE DRAWINGS

[Fig. 1] Fig. 1 is a schematically structural view showing an embodiment relating to the device for producing a magnetic resonance elastrogram (MRE) of the present invention.
[Fig. 2] Fig. 2 is a plan view showing the structure of the ball vibrator to be used in the production device shown in Fig. 1.
[Fig. 3] Fig. 3 is a side view showing the structure of the ball vibrator to be used in the production device shown in Fig. 1.

### MODE FOR CARRYING OUT THE INVENTION

Hereinafter, details, other features and advantages of the present invention will be described.

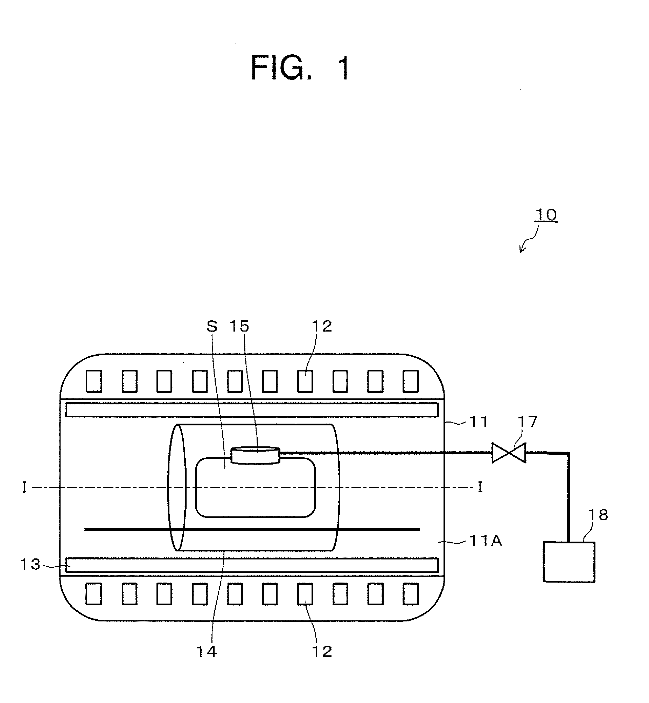

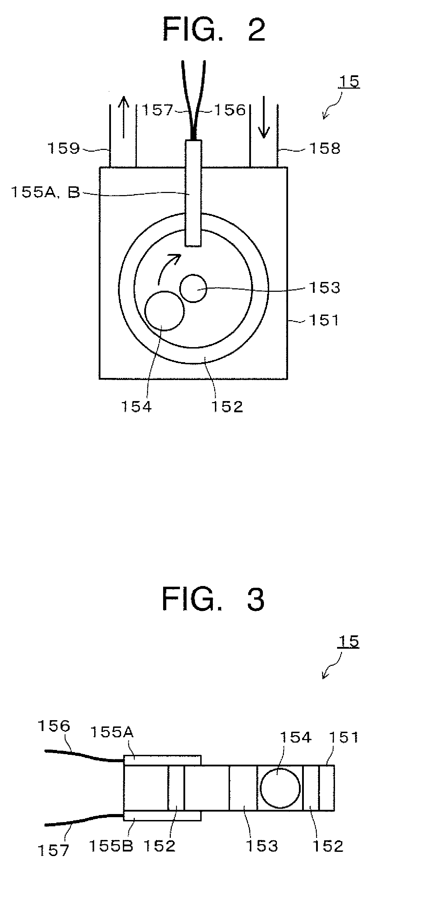

Fig. 1 is a schematically structural view showing an embodiment relating to the device for producing a magnetic resonance elastrogram (hereinafter, often abbreviated as "MRE") of the present invention, and Figs. 2 and 3 are structural views of the ball vibrator to be used in the magnetic resonance elastogram (MRE). Fig. 2 is a plan view of the ball vibrator, and Fig. 3 is a side view of the ball vibrator.

The MRE producing device 10 shown in Fig. 1 includes a magnetic resonance imaging device (MRI, hereinafter, often abbreviated as "MRI") 11 and a static magnetic field coil 12 functioning as a superconducting magnet which is embedded in the periphery wall thereof so as to wind around the center axis "I-I" in the long direction of the MRI 11. Then, a gradient coil 13 is disposed in the cavity 11A of the MRI 11 so as to be along the periphery wall thereof. Moreov er, a cylindrical RF coil 14 is disposed in the MRI 11.

Here, the static magnetic field coil 12 as the superconducting magnet, the gradient coil 13 and the RF coil 14 can be made from the ones commercially available.

A human subject S is disposed in the RF coil 14 in the cavity 11A of the MRI 11 such that a ball vibrator 15 is contacted with the upper portion of the human subject S. Since the ball vibrator 15 can generate an extremely large vibration, an MRE as will be described below c an be produced by disposing the ball vibrator 15 in contact with any portion of the human subject S. Preferably, the intended MRE can be produced absolutely and precisely by disposing the ball vibrator 15 in the vicinity of the diseased tissue of the human subject S.

As shown in Figs. 2 and 3, the ball vibrator 15 includes a case member 151 made of, e.g., plastic material and a circular ring-shaped member 152 made of, e.g., plastic material formed in the case member 151. A center member 153 such as a screw is formed at the center of the ring-shaped member 152 so as to penetrate through the case member 151. Moreover, a non-magnetic spherical ball 154 is provided in the space formed between the ring-shaped member 152 and the center member 153.

Furthermore, a compressor 18 is connected with the case member 151 via a tube 158 and a regulator 17. Thereby, a compressed air generated at the compressor 18 is controlled in pressure at the regulator 17, and introduced into the case member 151, t hat is, the ball vibrator 15 via the tube 158 so that the ball 154 is rotated around the center member 153 along the inner surface of the ring -shaped member 152, that is, along the circumferential direction thereof. As a result, a vibration is generated due to the centrifugal force accompanied by the rotation of the ball 154 in the circumferential direction of the ring-sbaped member 152.

The compressed air introduced into the case member 151, that is, the ball vibrator 15 is discharged outside from a tube 159.

Since the ball vibrator 15 is disposed in the MRI 11 as described above and operated under the state of a strong magnetic field of several teslas, the motion in the circumferential direction of the ball 154 is disturbed and thus, the intended vibration cannot be generated at the ball vibrator 15 if the ball 154 has magnetism.

Since the ball 154 is required to be smoothly rotated along the inner surface of the ring -shaped member 152, the ball 154 is preferably made of a material with surface smoothness such as PTFE.

Light sensors 155A and 155B are provided in the case member 151 such that the forefronts of the light sensors 155A and 155B are protruded in the space formed between the ring -shaped member 152 and the center member 153. Therefore, the rotational velocity of the ball 154, rotated in the circumferential direction of the ring-shaped member 152, is always monitored by the light sensors 155A and 155B. Concretely, a light with a prescribed wavelength is alwa ys transmitted to the light sensor 155A from an operating system (not shown) via an optical fiber 156, and irradiated downward in the case member 151. On the other hand, the light sensor 155B, disposed oppo site to the light sensor 155A, receives the light irradiated from the light sensor 155A and feeds back the optical signal relating to the received light to the operating system (not shown).

As apparent from the aforementioned description, the light sensors 155A and 155B function only as irradiating the light and receiving the irradiated light so that a light-emitting element as a light generating means for generating the light by the application of voltage and a light -receiving element as a light receiving means for converting the received light into the corresponding electrical signal are installed in the operating system.

Under this circumstance, when the motion in the circumferential direction of the ball 154 is conducted along the inner surface of the ring-shaped member 152, the light reception at the light sensor 155B is disturbed when the ball 154 is passed through the space between the light sensors 155A and 155B so that the electrical signal to be transmitted to the operating system (not shown) relating to the received light at the light sensor 155B is stopped. On the other hand, since the motion in the circumferential direction of the ball 154 is continuously conducted in terms of time when the MRE is produced, the electrical signal to be received at the operating system is stopped at a prescribed period of time. Therefore, the rotational velocity in the motion of the circumferential direction of the ball 154 can be monitored by measuring the time per the non-reception of the electrical signal and calculating the period of time, that is, the frequency about the non-reception of the electrical signal.

By controlling the regulator 17 and controlling the pressure of the compressed air to be introduced into the ball vibrator 15 appropriately on the basis of the monitori ng results of the light sensors 155A and 155B, the rotational number of the ball 154 can be always controlled constantly. As a result, the constant vibration, that is, the alternate stress can be always applied to the human subject S and the intended MRE reflecting the hardness of the diseased tissue can be easily produced.

Since the rotational number of the ball 154 in the circumferential direction in the ball vibrator 15 can be always monitored, the rotational number can be freely controlled so that in view of the hardness of the diseased tissue, the vibration, that is, the alternate stress commensurate with the diseased tissues can be freely formed. As a result, the intended MRE commensurate with the hardness of the diseased tissue can be appropriately produced.

Then, an MRE producing method, according to the present invention, using the MRE producing device shown in Fig. 1 will be described.

The human subject S is disposed in the RF coil 14 of the MRI 11 so that the ball vi brator 15 shown in Figs. 2 and 3 are attached in contacted with the human subject S in the vicinity of the diseased tissue of the human subject S. Then, a gigantic static magnetic field of several teslas is applied to the human subject S from the static magnetic field coil 12 so as to generate proton nuclear magnetic resonance. Then, an MRE pulse sequence is employed for the human subject S. Concretely, a high frequency pulse is applied to the human subject S from the RF coil 14 so as to produce the MRE of the diseased tissue of the human subject S. The frequency of the high frequency pulse is set almost equal to the Larmor frequency of the proton procession.

Then, the gradient magnetic field is applied to the human subject S from the gradient coil 13. The application of the gradient magnetic field can be conducted below, for example.

Supposed that the direction from the feet to the head of the human subject S is set to a Z -axis, the gradient magnetic field Gz is applied so that the intensity of the magnetic field is gradually increased along the Z-axis. In this case, the protons belonging to the respective slices of the human subject S are resonated at the respective different Larmor frequencies. By controlling the frequency of the high frequency pulse from the RF coil 14, therefore, the energy relating to the high frequency pulse can be imparted and absorbed to the protons belonging to a predetermined slice.

The application of the high frequency pulse from the RF coil 14 is conducted under the gradient magnetic field Gz.

Since the slice selected by the application of the gradient magnetic field Gz is two-dimensional, the thus obtained signals relating to the selected slice must correspond to the plane positions of the selected slice. In order to conduct the correspondence operation, if the two-dimensional selected slice is an X-Y plane, a gradient magnetic field Gx is applied in the X-direction to conduct the frequency encoding and a gradient magnetic field Gy is applied to the Y-direction to conduct the phase encoding.

Concretely, if the gradient magnetic field Gy is applied in the Y-direction for a short period of time, the spins belonging to the area where the strong magnetic field is applied originate d from the gradient magnetic field Gy are rotated at high velocity and the spins belonging to the area where the weak magnetic field is applied originated from the gradient magnetic field Gy are rotated at low velocity. Therefore, after the gradient magnetic field Gy is removed, the spins with the respective different phases are generated in the Y-direction. Then, if the gradient magnetic field Gx is applied in the X -direction, the echo signals with the respective different frequencies, originated from the application of the high frequency pulse, are produced. According to the aforementioned operation, the slice selection (Z -direction) and the space encoding can be completed.

If the two-dimensional inverse Fourier transformation is conducted for the echo signals, the image expanded in the X-direction and the Y-direction can be reconstructed on the basis of the difference in phase.

In the present invention, when the MRE pulse sequence is employed, the vibration from the ball vibrator 15 is applied to the human subject S. In this case, since the vibration is applied directly to the human subject S, the alternate stress can be sufficiently applied to the human subject S. Therefore, since the shear waves generated from the alternate stress can be propagated in the interior of the human subject S and reached to the diseased tissue of the human subject S, the MRE reflecting the hardness of the diseased tissue can be produced.

In this point of view, if the MRE relating to a tumor (e. g., a liver tumor) of which the hardness of the diseased tissue mainly changes is observed, the state of the tumor can be easily recognized and the diagnosis for the diseased tissue of the tumor can be conducted.

Moreover, since the rotation in the circumferential direction of the ball 154 in the ball vibrator 15 is caused by the pressure of air, a large load can be applied to the ball 154 in comparison of a conventional technique using the sound pressure so that the rotation of the ball 154 can be conducted at high velocity. As a result, a large vibration can be caused by the centrifugal force accompanied by the high velocity rotation, and the aforementioned function/effect can be conspicuously exhibited.

In the present invention, since the MRE is produced using the MRI 11, the function/effect inherently belonging to the MRI of small burden on human subject originated from non -use of contrast agent and non-radiation exposure, and high contrast resolution can be exhibited. Moreover, the imaging is not disturbed by the bones of the human subject, different from the X -ray imaging, so that the images of vertebrae, spinal cord and cartilage can be obtained and the images relating to the concentration distribution of metabolite and the motional behavior of molecule can be also obtained, allowing early diagnosis for diseased tissue such as in a state of bad metabolism or blood flow.

Although the present invention was described in detail with reference to the above examples, this invention is not limited to the above disclosure and every kind of variation and modification may be made without departing from the scope of the present invention. For example, the ball vibrator cannot be employed only for the MRE production, but also for an y use as needs arises.

### EXPLANATION OF THE SYMBOLS

- 10: magnetic resonance elastogram (MRE) producing device
- 11: magnetic resonance imaging device (MRI)
- 12: static magnetic field coil
- 13: gradient coil
- 14: RF coil
- 15: ball vibrator
- 155A, 155B: light sensor
- 17: regulator
- 18: compressor

## Claims

1. A method for producing a magnetic resonance elastogram (MRE) using a magnetic resonance imaging device (MRI), comprising the steps of:
disposing a ball vibrator to generate a vibration caused by a centrifugal force accompanied by a rotation of a non-magnetic ball in a circumferential direction thereof around a center point thereof so as to be contacted with a prescribed portion of a subject of which an image is produced; and
producing a magnetic resonance elestogram (MRE) by employing a magnetic resonance elastogram (MRE) pulse sequence to said subject and using said vibration from said ball vibrator.

2. The producing method as set forth in claim 1,
wherein said rotation of said non-magnetic ball in said circumferential direction of said ball vibrator is caused by a pressure of air.

3. The producing method as set forth in claim 1 or 2,
wherein said ball vibrator includes a light sensor so that a rotational number of said non-magnetic ball in said circumferential direction is monitored by an on/off frequency of said light frequency.

4. The producing method as set forth in claim 3,
wherein said rotational number in said circumferential direction of said ball vibrator is controlled by adjusting said pressure of air.

5. A device for producing a magnetic resonance elastogram (MRE) using a magnetic resonance imaging device (MRI), comprising:
a ball vibrator disposed so as to be contacted with a prescribed portion of a subject of which an image is formed in a magnetic resonance imaging device (MRI) and for applying to said subject a vibration caused by a centrifugal force accompanied by a rotation of a non -magnetic ball in a circumferential direction thereof around a center point thereof; and
an MRE pulse sequence generating means for generating a magnetic resonance elastogram (MRE) pulse sequence to be employed for said subject and producing a magnetic resonance elastogram (MRE) in cooperation with said vibration from said ball vibrator.

6. The producing device as set forth in claim 5,
wherein said ball vibrator is configured such that said rotation of said non-magnetic ball in said circumferential direction of said ball vibrator is caused by a pressure of air.

7. The producing device as set forth in claim 5 or 6,
wherein said ball vibrator includes a light sensor so that a rotational number of said non -magnetic ball in said circumferential direction is monitored by an on/off freq uency of said light frequency.

8. The producing device as set forth in claim 7,
wherein said ball vibrator is configured such that said rotational number in said circumferential direction of said ball vibrator is controlled by adjusting said pressure o fair.

9. A ball vibrator for producing a magnetic resonance elastogram (MRE) which is configured so as to generate a vibration caused by a centrifugal force accompanied by a rotation of a non-magnetic ball in a circumferential direction thereof around a center point thereof in contacted with a prescribed portion of a subject of which an image is formed.

10. The ball vibrator as set forth in claim 9,
wherein said rotation of said non-magnetic ball in said circumferential direction is caused by a pressure of air.

11. The ball vibrator as set forth in claim 9 or 10, which is configured so as to include a light sensor so that a rotational number of said non-magnetic ball in said circumferential direction is monitored by an on/off frequency of said light frequency.

12. The ball vibrator as set forth in claim 11,
wherein said rotational number in said circumferential direction is controlled by adjusting said pressure of air.

13. A ball vibrator which is configured so as to generate a vibration cau sed by a centrifugal force accompanied by a rotation of a non-magnetic ball in a circumferential direction thereof around a center point thereof.

14. The ball vibrator as set forth in claim 13,
wherein said rotation of said non-magnetic ball in said circumferential direction is caused by a pressure of air.

15. The ball vibrator as set forth in claim 13 or 14, which is configured such so as to include a light sensor so that a rotational number of said non-magnetic ball in said circumferential direction is monitored by an on/off frequency of said light frequency.

16. The ball vibrator as set forth in claim 15,
wherein said rotational number in said circumferential direction is controlled by adjusting said pressure of air.
